## Europäisches Patentamt

(19) **European Patent Office**

**Office européen des brevets**

(11) Veröffentlichungsnummer: **0 046 213**
**B1**

(12) # EUROPÄISCHE PATENTSCHRIFT

(45) Veröffentlichungstag der Patentschrift:
**12.06.85**

(51) Int. Cl.⁴: **H 03 D 3/00, H 04 N 11/18**

(21) Anmeldenummer: **81105878.3**

(22) Anmeldetag: **24.07.81**

(54) **Verfahren und Schaltungsanordnung zum Demodulieren zeitdiskreter frequenzmodulierter Signale.**

(30) Priorität: **14.08.80 DE 3030853**

(43) Veröffentlichungstag der Anmeldung:
**24.02.82 Patentblatt 82/8**

(45) Bekanntmachung des Hinweises auf die Patenterteilung:
**12.06.85 Patentblatt 85/24**

(84) Benannte Vertragsstaaten:
**DE FR GB**

(56) Entgegenhaltungen:
**EP - A - 0 029 376**
**DE - A - 2 833 335**
**DE - A - 2 948 467**
**FR - A - 2 219 570**
**US - A - 3 956 623**
**US - A - 4 090 145**

(73) Patentinhaber: **Siemens Aktiengesellschaft, Berlin und München Wittelsbacherplatz 2, D-8000 München 2 (DE)**

(72) Erfinder: **Haussmann, Wolfgang, Dipl.-Ing., Untersbergstrasse 90, D-8000 München 90 (DE)**

## Beschreibung

Die Erfindung betrifft ein Verfahren und eine Schaltungsanordnung zum Demodulieren zeitdiskreter frequenzmodulierter Signale, bei denen das zu demodulierende Signal durch Verzögerungsglieder geleitet wird.

Die digitale Signalverarbeitung ermöglicht es, zahlreiche bisher in analoger Technik gelöste Aufgaben der Signalverarbeitung auch digital anzugehen. Hiervon gibt es aber verschiedene Ausnahmen. So wurde bisher zu den in analoger Technik verwendeten Demodulatoren für frequenzmodulierte Signale (FM-Signale) kein entsprechender digitaler Baustein beschrieben, der die Funktion einer FM-Demodulation mit vertretbarem Aufwand und in Echtzeit durchführen kann. Verschiedene Möglichkeiten, die digitalen Verfahren ähneln, haben sich in der Praxis als ungeeignet erwiesen. So sind Nulldurchgangs-Detektoren wenig geeignet, da durch den zwingend durchgeführten Abtastprozess gerade die Nulldurchgänge verlorengehen. Angestrebt wird also eine Verarbeitung der Abtastwerte mit den Funktionen eines FM-Demodulators, wobei Auswirkungen der Amplitudenmodulation unterdrückt beziehungsweise begrenzt werden.

Im einzelnen wurden zur Demodulation zeitdiskreter frequenzmodulierter Signale bisher verschiedene Möglichkeiten erhoben:

Die Verwendung einer digitalen Phasenregelschleife (vergleiche Kelly, Gupta: «The Digital PLL as a Near-Optimum FM Demodulator», IEEE Transaction on Communications, June 72) und die Methode eines nachgeführten adaptiven Filters (vergleiche Griffiths: «Rapid Measurement of Digital Instantaneous Frequency», IEEE Transactions of Acoustics, Speech and Signal Processing, April 75) führt zu Regelkreisen mit den hiermit verbundenen Problemen hinsichtlich beispielsweise Einschwingverhalten, Stabilität und so weiter.

Die auch bereits erwogene schnelle Fourier-Transformation (vergleiche Roth: «Effective Measurements Using Digital Signal Analysis», IEEE Spektrum, April 71) erfordert einen vergleichsweise hohen Rechenaufwand zur Demodulation, so dass eine Echtzeitverarbeitung überwiegend auf den Bereich niederer Trägerfrequenzen beschränkt bleibt.

Alle bereits diskutierten Verfahren benötigen also einen hohen Aufwand hinsichtlich der Systementwicklung und der Herstellung des entsprechenden Bausteins.

Es könnte weiterhin daran gedacht werden, zunächst digital die Frequenzmodulation in eine Amplitudenmodulation umzusetzen und erst dann die Amplitudenmodulation zu demodulieren. Zwar gibt es verschiedene Möglichkeiten zur Umwandlung von einer Frequenzmodulation in eine Amplitudenmodulation. Mit einer digitalen Amplitudendemodulation und einer digitalen Begrenzung verknüpfte Probleme sind aber derzeit noch nicht gelöst.

Es ist daher Aufgabe der Erfindung, ein Verfahren und eine Schaltungsanordnung zur Demodulation frequenzmodulierter Signale anzugeben, die in der Form von Abtastwerten vorliegen. Diese Aufgabe wird dadurch gelöst, dass drei Abtastproben des zu demodulierenden Signals derart miteinander verknüpft werden, dass das Ausgangssignal direkt der Momentanfrequenz proportional ist, die die drei Abtastproben enthält, dass dazu die Abtastproben in einem ersten Zeitpunkt T und einem um zwei Abtastperioden verzögerten Zeitpunkt $T + 2\,T_A$ addiert werden, dass die Summe durch den zweifachen Wert der Abtastprobe im Zeitpunkt $T + T_A$ dividiert wird, und dass aus dem Ergebnis der Division die Arcuscosinusfunktion ermittelt wird.

In einer vorteilhaften Weiterbildung ist vorgesehen, dass bei einem Verhältnis von 0,25 oder 0,75 der Momentanfrequenz des zu demodulierenden Signals und der Abtastfrequenz die Abtastproben in Zeitpunkten T und $T + 2\,T_A$ addiert werden, und dass die Summe durch einen der Abtastprobe im Zeitpunkt $T + T_A$ proportionalen Wert dividiert wird.

Beim erfindungsgemässen Verfahren ist das Ergebnis der Demodulation unabhängig von der Amplitude des abgetasteten Signals. Es liegt also eine Begrenzung vor. Ausserdem ist das Ergebnis auch unabhängig von der Phasenlage des Abtasttaktes.

Eine Schaltungsanordnung zur Durchführung des Verfahrens zeichnet sich dadurch aus, dass dem Eingang für das zu demodulierende Signal einerseits ein Verzögerungsglied und andererseits ein Addierer nachgeschaltet sind, dass zwischen dem Verzögerungsglied und dem Addierer ein weiteres Verzögerungsglied liegt, dass der Verbindungspunkt zwischen den beiden Verzögerungsgliedern und der Ausgang des Addierers mit den Adresseingängen eines Festwertspeichers in der Weise verbunden ist, dass jeweils das Rechenergebnis enthaltende Speicherzellen adressiert sind, und dass am Ausgang des Festwertspeichers das demodulierte Signal liegt.

Eine weitere Ausgestaltung der Erfindung besteht darin, dass bei Vorliegen niedriger Taktfrequenzen der Verbindungspunkt zwischen den beiden Verzögerungsgliedern und der Ausgang des Addierers anstelle des Festwertspeichers mit einem die Division durchführenden und die Arcuscosinusfunktion ermittelnden Rechenwerk verbunden sind.

Nachfolgend wird die Erfindung an Hand der Zeichnung näher erläutert.

Es zeigen:

Fig. 1 ein Ausführungsbeispiel der erfindungsgemässen Schaltungsanordnung mit einem Festwertspeicher,

Fig. 2 die Demodulationskennlinie des nach der Erfindung arbeitenden Demodulators.

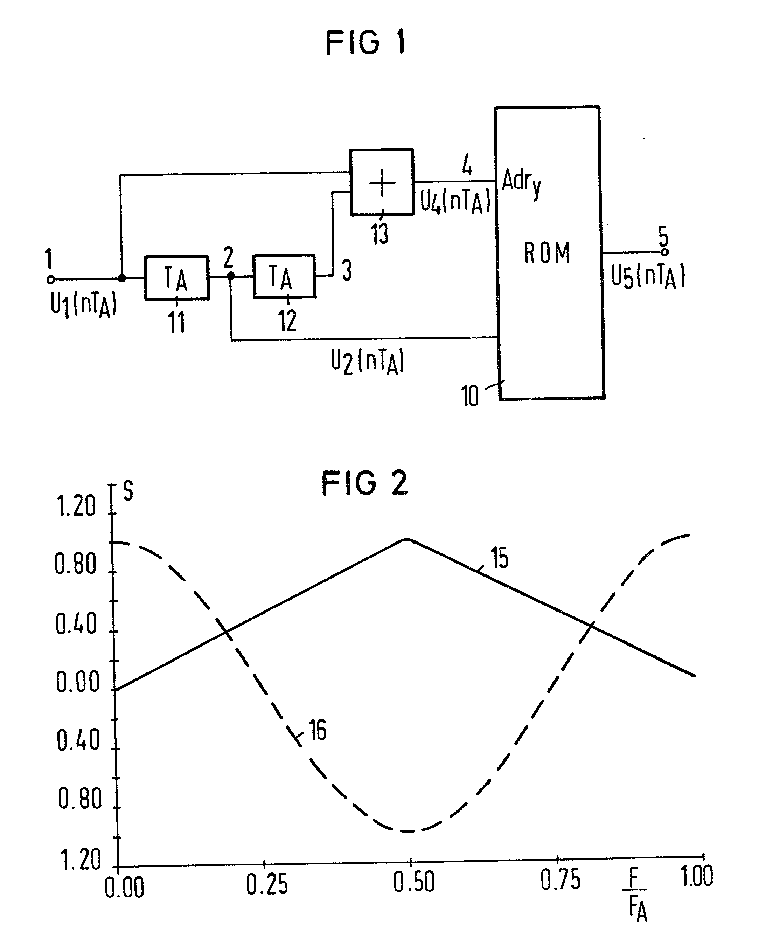

Fig. 1 zeigt ein Ausführungsbeispiel der erfindungsgemässen Schaltungsanordnung mit einem Festwertspeicher 10. An einem Eingangsanschluss 1 liegt das zu demodulierende FM-Si-

gnal $U_1$ $(nT_A)$ in der Form einer Folge von Abtastwerten. Dem Eingang 1 ist ein erstes Verzögerungsglied 11 nachgeschaltet, indem das Eingangssignal um eine Taktperiode $T_A$ verzögert wird. Somit wird an einem Verbindungspunkt 2 das um eine Taktperiode $T_A$ verzögerte Eingangssignal erhalten. Dem Verbindungspunkt 2 ist ein zweites Verzögerungsglied 12 nachgeschaltet, indem ein Signal vom Verbindungspunkt 2 ebenfalls um eine Taktperiode $T_A$ verzögert wird. Somit kann am Ausgang 3 des Verzögerungsglieds 12 das um zwei Taktperioden $T_A$ verzögerte Ein-gangssignal abgegriffen werden. Dem Verzöge-rungsglied 12 und dem Eingang 1 ist ein Addierer 13 nachgeschaltet, dessen Ausgang 4 mit dem Festwertspeicher 10 verbunden ist. Weiterhin ist der Verbindungspunkt 2 direkt an den Festwertspeicher 10 angeschlossen. Am Ausgang 4 des Addierers 13 liegt so die Summe aus dem unverzögerten und dem um zwei Taktperioden $T_A$ verzögerten Eingangssignal an. Die Signale am Ausgang 4 und am Verbindungspunkt 2 steuern so di-rekt die Adresseneingänge des Festwertspei-chers 10 an, indem die Division und das Bilden der Arcuscosinusfunktion vorgenommen wird.

An einer gewählten Speicherstelle des Festwertspeichers 10 liegt so ein Wert, der proportional zur Frequenz ist, die den an den Punkten 1, 2 und 3 anliegenden Abtastwerten zugrunde liegt. Am Ausgang 5 des Festwertspeichers 10 wird so das demodulierte Signal $U_5$ $(nT_A)$ in der Form einer Folge von Abtastwerten erhalten.

Wenn der FM-Demodulator als Filter betrachtet wird, so ergibt sich folgende Gleichung:
$$U_5(nT_A) = C. \arccos\{[U_4(nT_A)]/(2U_2(nT_A)]\}$$
mit den z-Transformierten:
$$U_4(z) = U_1(z) \cdot (1 + z^{-2}) \text{ und } U_2(z) = U_1(z) \cdot z^{-1},$$
wobei C eine festzulegende Normierungskonstante ist.

Fig. 2 zeigt die Demodulationskennlinie 15 des nach der Erfindung aufgebauten Demodulators, wobei die Achsen jeweils geeignet normiert sind. Dabei ist auf der X-Achse die Momentanfrequenz F des zu demodulierenden FM-Signals bezogen auf die Taktfrequenz $F_A = 1/T_A$ aufgetragen. Auf der Y-Achse ist das demodulierte Signal S angegeben.

Wie aus der Fig. 2 zu ersehen ist, bildet die Demodulationskennlinie eine Gerade. Weiterhin ist die Demodulationskennlinie 16 eines FM-Demodulators dargestellt, die erhalten wird, wenn auf die Bildung der Arcuscosinusfunktion verzichtet wird. Diese Kennlinie 16 stellt eine Cosinusfunktion dar, und es ist zu erkennen, dass für FM-Signale im Bereich um das 0,25fache und das 0,75fache der Abtastfrequenz auf die Bildung des Arcuscosinuswerts verzichtet werden kann, weil in diesen Bereichen die entstandene Demodula-tionskennlinie 16 nur unwesentliche Nichtlineari-täten in einem grösseren Bereich enthält.

**Patentansprüche**

1. Verfahren zum Demodulieren zeitdiskreter frequenzmodulierter Signale, bei dem das zu demodulierende Signal $[U_1$ $(nT_A)]$ durch Verzöge-rungsglieder (11, 12, 13) geleitet wird, dadurch gekennzeichnet, dass drei Abtastproben des zu demodulierenden Signals $[U_1(nT_A)]$ derart mit-einander verknüpft werden, dass das Ausgangs-signal $[U_5$ $(nT_A)]$ direkt der Momentanfrequenz (F) proportional ist, die die drei Abtastproben enthält, dass dazu die Abtastproben in einem ersten Zeitpunkt (T) und einem um zwei Abtastperioden $(T_A)$ verzögerten Zeitpunkt $(T+2$ $T_A)$ addiert werden, dass die Summe durch den zweifachen Wert der Abtastprobe im Zeitpunkt $(T+T_A)$ dividiert wird, und dass aus dem Ergebnis der Division die Arcuscosinusfunktion ermittelt wird.

2. Verfahren nach Anspruch, dadurch gekennzeichnet, dass bei einem Verhältnis von 0,25 oder 0,75 der Momentanfrequenz (F) des zu demodulierenden Signals und der Abtastfrequenz ($F_A$) die Abtastproben in Zeitpunkten T und $(T+2T_A)$ addiert werden, und dass die Summe durch einen der Abtastprobe im Zeitpunkt $(T+T_A)$ proportionalen Wert dividiert wird.

3. Schaltungsanordnung zur Durchführung des Verfahrens nach einem der Ansprüche 1 bis 2, dadurch gekennzeichnet, dass dem Eingang für das zu demodulierende Signal $[U_1(nT_A)]$ einer-seits ein Verzögerungsglied (11) und andererseits ein Addierer (13) nachgeschaltet sind, dass zwischen dem Verzögerungsglied (11) und dem Addierer (13) ein weiteres Verzögerungsglied (12) liegt, dass der Verbindungspunkt (2) zwischen den beiden Verzögerungsgliedern (11, 12) und der Ausgang des Addierers (13) mit den Adresseingängen eines Festwertspeichers (10) in der Weise verbunden ist, dass jeweils das Rechenergebnis enthaltende Speicherzellen adressiert sind, und dass am Ausgang des Festwertspeichers das demodulierte Signal liegt.

4. Schaltungsanordnung zur Durchführung des Verfahrens nach Anspruch 3, dadurch gekennzeichnet, dass bei Vorlegen niedriger Taktfrequenzen der Verbindungspunkt (2) zwischen den beiden Verzögerungsgliedern und der Ausgang des Addierers (13) anstelle des Festwertspeichers mit einem die Division durchführenden und die Arcuscosinusfunktion ermittelnden Re-chenwerk verbunden sind.

**Claims**

1. A method of demodulating frequency-modulated signals, which are of discrete values in time, wherein the signal $[U_1(nT_A)]$ to be demodulated is passed through delay elements (11, 12, 13), characterised in that three scan samples of the signal $[U_1(nT_A)]$ to be demodulated are connected to one another in such manner that the output signal $[U_5(nT_A)]$ is directly proportional to the instantaneous frequency (F) which comprises the three scan samples, that the scan samples are added thereto at a first point of time (T) and at a point of time $(T+2$ $T_A)$ which is delayed by two sampling periods $(T_A)$, that the sum is divided by the two-fold value of the scan sample at the point of time $(T+T_A)$, and that the arc cos function is determined from the result of the division.

2. A method as claimed in Claim 1, characterised in that in the case of a ratio of 0.25 or 0.75 of the instantaneous frequency (F) of the signal to be demodulated and the sampling frequency $(F_A)$ the scan samples are added at points of time T and $(T+2T_A)$, and that the sum is divided by a value which is proportional to the scan sample at the point of time $(T+T_A)$.

3. A circuit arrangement for carrying out the method as claimed in one of Claims 1 to 2, characterised in that on the one hand the input for the signal $[U_1(nT_A)]$ to be demodulated is followed by a delay element (11) and, on the other hand, by an adder (13), that between the delay element (11) and the adder (13) there is arranged a further delay element (12), that both the junction point (2) between the two delay elements (11, 12) and the output of the adder (13) are connected to address inputs of a read-only store (10) in such a manner that storage cells which contain the calculating result are respectively addressed, and that the demodulated signal is provided from the output of the read-only memory

4. A circuit arrangement for carrying out the method as claimed in Claim 3, characterised in that when low clock pulse frequencies are presented at the junction point (2) between the two delay elements, and the output of the adder (13) are connected to a calculating unit which carries out the division and determines the arc cos function instead of being connected to the read-only store.

**Revendications**

1. Procédé pour démoduler des signaux discrets dans le temps et modulés en fréquence et selon lequel le signal devant être démodulé [$(U_1(nT_A)]$ est transmis par des lignes à retard (11, 12, 13), caractérisé par le fait que trois échantillons d'exploration du signal devant être démodulé $[U_1(nT_A)]$ sont combinés entre-eux de telle sorte que le signal $[U_5(nT_A)]$ est directement proportionnel à la fréquence instantanée F que contiennent les trois échantillons d'exploration, qu'à cet effet les échantillons d'exploration obtenus à un premier instant (T) et à un instant $(T+2T_A)$ retardé de deux périodes d'exploration $(T_A)$ sont additionnés, que la somme est divisée le double de la valeur de l'échantillon d'exploration à l'instant $(T+T_A)$ et que la fonction arc cosinus est déterminée à partir des résultats de la division.

2. Procédé suivant la revendication 1, caractérisé par le fait que dans le cas où le rapport de la fréquence instantanée (F) du signal à démoduler à la fréquence d'exploration $(F_A)$ est égal à 0,25 ou 0,75, les échantillons d'exploration obtenus aux instants T et $(T+2T_A)$ sont ajoutés, et que la somme est divisée par une valeur proportionnelle à l'échantillon d'exploration à l'instant $(T+T_A)$.

3. Montage pour la mise en œuvre du procédé suivant l'une des revendications 1 et 2, caractérisé par le fait que d'une part la ligne à retard (11) et d'autre part l'additionneur (13) sont branchés en aval de l'entrée prévue pour le signal à démoduler $[U_1(nT_A)]$, qu'une autre ligne à retard est disposée entre la ligne à retard (11) et l'additionneur (13), et que le point de jonction (2) entre les deux lignes à retard (11, 12) et la sortie de l'additionneur (13) sont reliés aux entrées d'adressage d'une mémoire morte (10) de telle sorte que des cellules respectives de mémoire contenant le résultat des calculs sont adressées et que le signal démodulé est présent à la sortie de la mémoire morte.

4. Montage pour la mise en œuvre du procédé suivant la revendication 3, caractérisé par le fait que dans le cas de la présence de fréquences d'horloge faibles, le point de jonction (2) entre les deux lignes à retard et la sortie de l'additionneur (13) sont reliés, non pas à la mémoire morte, mais à une unité de calcul effectuant la division et déterminant la fonction arc cosinus.

# FIG 1

$U_4(nT_A)$

4

Adr y

$+$

13

ROM

10

1

$U_1(nT_A)$

$T_A$

11

2

$T_A$

12

3

$U_2(nT_A)$

5

$U_5(nT_A)$

# FIG 2

S

1.20

0.80

0.40

0.00

0.40

0.80

1.20

15

16

0.00    0.25    0.50    0.75    1.00

$\dfrac{F}{F_A}$